# EUROPEAN PATENT APPLICATION

(11) **EP 3 876 036 A1**
(43) Date of publication of application: **08.09.2021**
(21) Application number: 20160840.3
(22) Date of filing: 04.03.2020
(51) Int. Cl.: G03F 7/20, G01N 21/956, G01N 21/21

(54) **VIBRATION ISOLATION SYSTEM AND ASSOCIATED APPLICATIONS IN LITHOGRAPHY**

(71) Applicant: ASML Netherlands B.V., 5500 AH Veldhoven (NL)
(72) Inventor: VAN DEN BERG, Christiaan Ruben, Veldhoven (NL); BAGGEN, Marcel Koenraad Marie, 5500 AH Veldhoven (NL); BAGGEN, Mark Constant Johannes, 5504 DR Veldhoven (NL); BUTLER, Hans, 5500 AH Veldhoven (NL); PEIJSTER, Jerry Johannes Martinus, 5500 AH Veldhoven (NL); KUINDERSMA, Lucas, 5500 AH Veldhoven (NL)
(74) Representative: ASML Netherlands B.V.

(57) **Abstract**

An apparatus for improving vibration isolation for a vibration sensitive device, such as metrology device or lithographic apparatus is disclosed. The apparatus comprises a module frame for supporting a projection module of the vibration sensitive device; and an intermediate frame for supporting an object support system of the vibration sensitive device, said object support system being configured for supporting an object. The intermediate frame is suspended from the module frame with a connection between the module frame and the intermediate frame being stiff in at least a first direction, the first direction being perpendicular to a main surface plane of said object.

## Description

### FIELD

The present invention relates to a vibration isolation system and in relation to metrology applications in the manufacture of integrated circuits.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") at a patterning device (e.g., a mask) onto a layer of radiation-sensitive material (resist) provided on a substrate (e.g., a wafer).

To project a pattern on a substrate a lithographic apparatus may use electromagnetic radiation. The wavelength of this radiation determines the minimum size of features which can be formed on the substrate. Typical wavelengths currently in use are 365 nm (i-line), 248 nm, 193 nm and 13.5 nm. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Low-k₁ lithography may be used to process features with dimensions smaller than the classical resolution limit of a lithographic apparatus. In such process, the resolution formula may be expressed as CD = k₁×λ/NA, where λ is the wavelength of radiation employed, NA is the numerical aperture of the projection optics in the lithographic apparatus, CD is the "critical dimension" (generally the smallest feature size printed, but in this case half-pitch) and k₁ is an empirical resolution factor. In general, the smaller k₁ the more difficult it becomes to reproduce the pattern on the substrate that resembles the shape and dimensions planned by a circuit designer in order to achieve particular electrical functionality and performance. To overcome these difficulties, sophisticated fine-tuning steps may be applied to the lithographic projection apparatus and/or design layout. These include, for example, but not limited to, optimization of NA, customized illumination schemes, use of phase shifting patterning devices, various optimization of the design layout such as optical proximity correction (OPC, sometimes also referred to as "optical and process correction") in the design layout, or other methods generally defined as "resolution enhancement techniques" (RET). Alternatively, tight control loops for controlling a stability of the lithographic apparatus may be used to improve reproduction of the pattern at low k1.

During the manufacturing process there is a need to inspect the manufactured structures and/or to measure characteristics of the manufactured structures. Suitable inspection and metrology apparatuses are known in the art. One of the known metrology apparatuses is a scatterometer and, for example, a dark field scatterometer.

Patent application publication US20160161864A1, patent application publication US20100328655A1 and patent application publication US20060066855A1 discuss embodiments of a photolithographic apparatus and embodiments of a scatterometer. The cited documents are herein incorporated by reference.

In scatterometer based metrology or inspection apparatuses, precise control of wafer position is required to position a wafer such that features with small CDs can be precisely measured. High precision wafer positioning cannot be achieved only by using high precision wafer stages as the wafer positioning performance can be degraded by vibrations, such as ground vibrations and wafer stage induced disturbances. Hence, there is a strong desire to improve the existing scatterometer based metrology or inspection apparatuses such that vibration induced performance degradation of such apparatuses are reduced or minimized.

### SUMMARY

In a first aspect of the invention, there is provided an apparatus for improving vibration isolation for a vibration sensitive device, comprising: a module frame for supporting a projection module of the vibration sensitive device; and an intermediate frame for supporting an object support system of the vibration sensitive device, said object support system being configured for supporting an object; wherein the intermediate frame is suspended from the module frame with a connection between the module frame and the intermediate frame being stiff in at least a first direction, the first direction being perpendicular to a main surface plane of said object, said plane or a plane parallel thereto defining a second and third direction.

In a second aspect of the invention, there is provided a metrology or inspection device comprising an apparatus defined in accordance with the first aspect of the invention.

In a third aspect of the invention, there is provided a lithographic exposure device comprising an apparatus defined in accordance with the first aspect of the invention.

### BRIEF DESCRIPTION OF THE DRAWINGS

Embodiments of the invention will now be described, by way of example only, with reference to the accompanying schematic drawings, in which:
- Figure 1 depicts a schematic overview of a lithographic apparatus;
- Figure 2 depicts a schematic overview of a lithographic cell;
- Figure 3 depicts a schematic representation of holistic lithography, representing a cooperation between three key technologies to optimize semiconductor manufacturing;
- Figure 4 depicts a schematic overview of a scatterometry apparatus used as a metrology device, which may comprise a vibration isolation system according to embodiments of the invention;
- Figure 5 depicts a schematic overview of a level sensor apparatus which may comprise a vibration isolation system according to embodiments of the invention;
- Figure 6 depicts a schematic overview of an alignment sensor apparatus which may comprise a vibration isolation system according to embodiments of the invention;
- Figure 7 depicts a schematic overview of an existing scatterometer based metrology device according to a prior art example;
- Figure 8 depicts a schematic overview of an improved vibration isolation system incorporated in a scatterometer based metrology device according to a first embodiment of the invention;
- Figure 9 depicts a schematic overview of an improved vibration isolation system incorporated in a scatterometer based metrology device according to a second embodiment of the invention;
- Figure 10 depicts a schematic overview of an improved vibration isolation system incorporated in a scatterometer based metrology device according to a third embodiment of the invention;
- Figure 11 depicts a schematic overview of an improved vibration isolation system incorporated in a scatterometer based metrology device according to a fourth embodiment of the invention.

### DETAILED DESCRIPTION

In the present document, the terms "radiation" and "beam" are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range of about 5-100 nm).

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

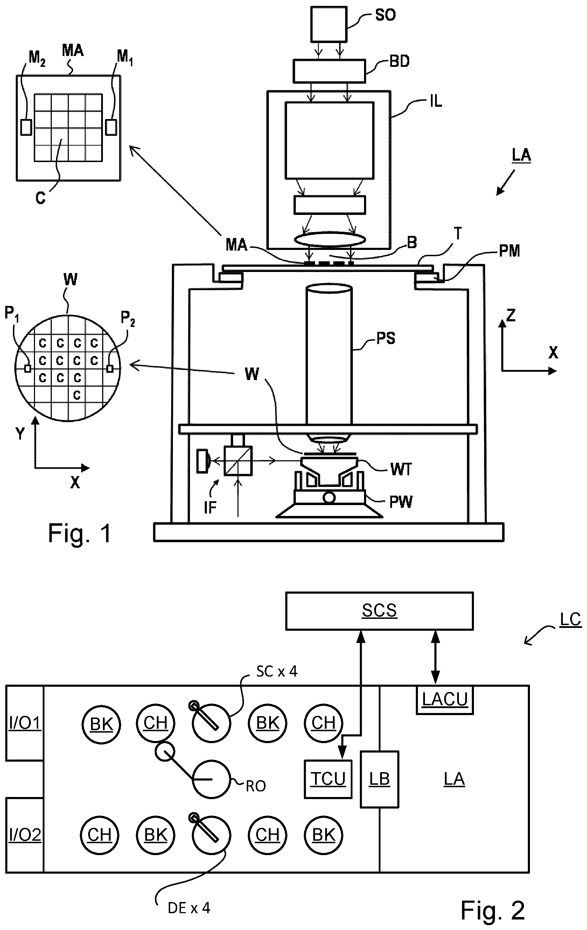

Figure 1 schematically depicts a lithographic apparatus LA. The lithographic apparatus LA includes an illumination system (also referred to as illuminator) IL configured to condition a radiation beam B (e.g., UV radiation, DUV radiation or EUV radiation), a mask support (e.g., a mask table) MT constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support MT, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT can be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks P1, P2. Although the substrate alignment marks P1, P2 as illustrated occupy dedicated target portions, they may be located in spaces between target portions. Substrate alignment marks P1, P2 are known as scribe-lane alignment marks when these are located between the target portions C.

As shown in Figure 2 the lithographic apparatus LA may form part of a lithographic cell LC, also sometimes referred to as a lithocell or (litho)cluster, which often also includes apparatus to perform pre- and post-exposure processes on a substrate W. Conventionally these include spin coaters SC to deposit resist layers, developers DE to develop exposed resist, chill plates CH and bake plates BK, e.g. for conditioning the temperature of substrates W e.g. for conditioning solvents in the resist layers. A substrate handler, or robot, RO picks up substrates W from input/output ports I/O1, I/O2, moves them between the different process apparatus and delivers the substrates W to the loading bay LB of the lithographic apparatus LA. The devices in the lithocell, which are often also collectively referred to as the track, are typically under the control of a track control unit TCU that in itself may be controlled by a supervisory control system SCS, which may also control the lithographic apparatus LA, e.g. via lithography control unit LACU.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), etc. For this purpose, inspection tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus, which may also be referred to as a metrology apparatus, is used to determine properties of the substrates W, and in particular, how properties of different substrates W vary or how properties associated with different layers of the same substrate W vary from layer to layer. The inspection apparatus may alternatively be constructed to identify defects on the substrate W and may, for example, be part of the lithocell LC, or may be integrated into the lithographic apparatus LA, or may even be a stand-alone device. The inspection apparatus may measure the properties on a latent image (image in a resist layer after the exposure), or on a semi-latent image (image in a resist layer after a post-exposure bake step PEB), or on a developed resist image (in which the exposed or unexposed parts of the resist have been removed), or even on an etched image (after a pattern transfer step such as etching).

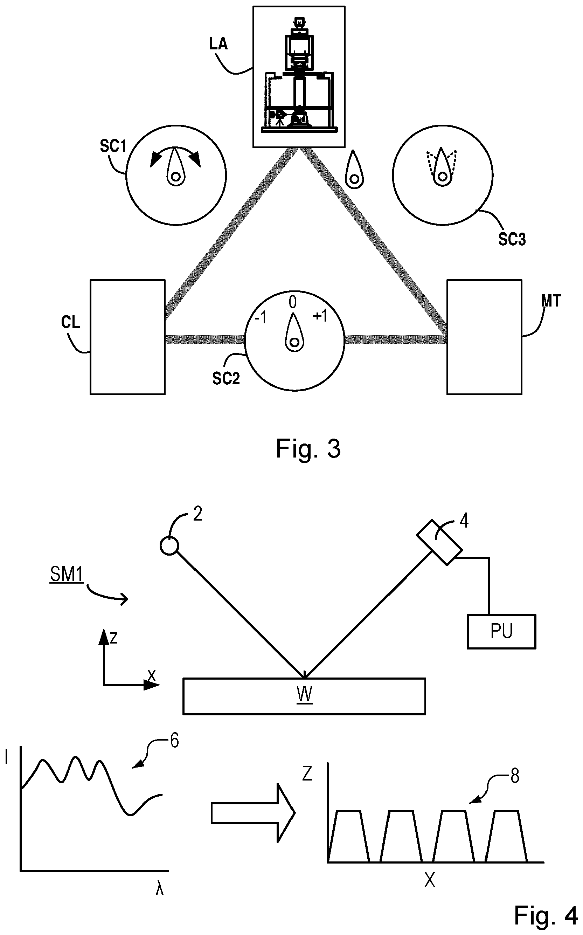

Typically the patterning process in a lithographic apparatus LA is one of the most critical steps in the processing which requires high accuracy of dimensioning and placement of structures on the substrate W. To ensure this high accuracy, three systems may be combined in a so called "holistic" control environment as schematically depicted in Fig. 3. One of these systems is the lithographic apparatus LA which is (virtually) connected to a metrology tool MT (a second system) and to a computer system CL (a third system). The key of such "holistic" environment is to optimize the cooperation between these three systems to enhance the overall process window and provide tight control loops to ensure that the patterning performed by the lithographic apparatus LA stays within a process window. The process window defines a range of process parameters (e.g. dose, focus, overlay) within which a specific manufacturing process yields a defined result (e.g. a functional semiconductor device) - typically within which the process parameters in the lithographic process or patterning process are allowed to vary.

The computer system CL may use (part of) the design layout to be patterned to predict which resolution enhancement techniques to use and to perform computational lithography simulations and calculations to determine which mask layout and lithographic apparatus settings achieve the largest overall process window of the patterning process (depicted in Fig. 3 by the double arrow in the first scale SC1). Typically, the resolution enhancement techniques are arranged to match the patterning possibilities of the lithographic apparatus LA. The computer system CL may also be used to detect where within the process window the lithographic apparatus LA is currently operating (e.g. using input from the metrology tool MT) to predict whether defects may be present due to e.g. sub-optimal processing (depicted in Fig. 3 by the arrow pointing "0" in the second scale SC2).

The metrology tool MT may provide input to the computer system CL to enable accurate simulations and predictions, and may provide feedback to the lithographic apparatus LA to identify possible drifts, e.g. in a calibration status of the lithographic apparatus LA (depicted in Fig. 3 by the multiple arrows in the third scale SC3).

In lithographic processes, it is desirable to make frequently measurements of the structures created, e.g., for process control and verification. Tools to make such measurement are typically called metrology tools MT. Different types of metrology tools MT for making such measurements are known, including scanning electron microscopes or various forms of scatterometer metrology tools MT. Scatterometers are versatile instruments which allow measurements of the parameters of a lithographic process by having a sensor in the pupil or a conjugate plane with the pupil of the objective of the scatterometer, measurements usually referred as pupil based measurements, or by having the sensor in the image plane or a plane conjugate with the image plane, in which case the measurements are usually referred as image or field based measurements. Such scatterometers and the associated measurement techniques are further described in patent applications US20100328655A1, US2011102753A1, US20120044470A, US20110249244, US20110026032 or EP1,628,164A, incorporated herein by reference in their entirety. Aforementioned scatterometers may measure gratings using light from soft x-ray and visible to near-IR wavelength range.

In a first embodiment, the scatterometer MT is an angular resolved scatterometer. In such a scatterometer reconstruction methods may be applied to the measured signal to reconstruct or calculate properties of the grating. Such reconstruction may, for example, result from simulating interaction of scattered radiation with a mathematical model of the target structure and comparing the simulation results with those of a measurement. Parameters of the mathematical model are adjusted until the simulated interaction produces a diffraction pattern similar to that observed from the real target.

In a second embodiment, the scatterometer MT is a spectroscopic scatterometer MT. In such spectroscopic scatterometer MT, the radiation emitted by a radiation source is directed onto the target and the reflected or scattered radiation from the target is directed to a spectrometer detector, which measures a spectrum (i.e. a measurement of intensity as a function of wavelength) of the specular reflected radiation. From this data, the structure or profile of the target giving rise to the detected spectrum may be reconstructed, e.g. by Rigorous Coupled Wave Analysis and non-linear regression or by comparison with a library of simulated spectra.

In a third embodiment, the scatterometer MT is a ellipsometric scatterometer. The ellipsometric scatterometer allows for determining parameters of a lithographic process by measuring scattered radiation for each polarization states. Such metrology apparatus emits polarized light (such as linear, circular, or elliptic) by using, for example, appropriate polarization filters in the illumination section of the metrology apparatus. A source suitable for the metrology apparatus may provide polarized radiation as well. Various embodiments of existing ellipsometric scatterometers are described in US patent applications 11/451,599, 11/708,678, 12/256,780, 12/486,449, 12/920,968, 12/922,587, 13/000,229, 13/033,135, 13/533,110 and 13/891,410 incorporated herein by reference in their entirety.

A metrology apparatus, such as a scatterometer, is depicted in Figure 4. It comprises a broadband (white light) radiation projector 2 which projects radiation onto a substrate W. The reflected or scattered radiation is passed to a spectrometer detector 4, which measures a spectrum 6 (i.e. a measurement of intensity as a function of wavelength) of the specular reflected radiation. From this data, the structure or profile 8 giving rise to the detected spectrum may be reconstructed by processing unit PU, e.g. by Rigorous Coupled Wave Analysis and non-linear regression or by comparison with a library of simulated spectra as shown at the bottom of Figure 3. In general, for the reconstruction, the general form of the structure is known and some parameters are assumed from knowledge of the process by which the structure was made, leaving only a few parameters of the structure to be determined from the scatterometry data. Such a scatterometer may be configured as a normal-incidence scatterometer or an oblique-incidence scatterometer.

Overall measurement quality of a lithographic parameter via measurement of a metrology target is at least partially determined by the measurement recipe used to measure this lithographic parameter. The term "substrate measurement recipe" may include one or more parameters of the measurement itself, one or more parameters of the one or more patterns measured, or both. For example, if the measurement used in a substrate measurement recipe is a diffraction-based optical measurement, one or more of the parameters of the measurement may include the wavelength of the radiation, the polarization of the radiation, the incident angle of radiation relative to the substrate, the orientation of radiation relative to a pattern on the substrate, etc. One of the criteria to select a measurement recipe may, for example, be a sensitivity of one of the measurement parameters to processing variations. More examples are described in US patent application US20160161863 and published US patent application US 20160370717A1 incorporated herein by reference in its entirety.

Another type of metrology tool used in IC manufacture is a topography measurement system, level sensor or height sensor. Such a tool may be integrated in the lithographic apparatus, for measuring a topography of a top surface of a substrate (or wafer). A map of the topography of the substrate, also referred to as height map, may be generated from these measurements indicating a height of the substrate as a function of the position on the substrate. This height map may subsequently be used to correct the position of the substrate during transfer of the pattern on the substrate, in order to provide an aerial image of the patterning device in a properly focus position on the substrate. It will be understood that "height" in this context refers to a dimension broadly out of the plane to the substrate (also referred to as Z-axis). Typically, the level or height sensor performs measurements at a fixed location (relative to its own optical system) and a relative movement between the substrate and the optical system of the level or height sensor results in height measurements at locations across the substrate.

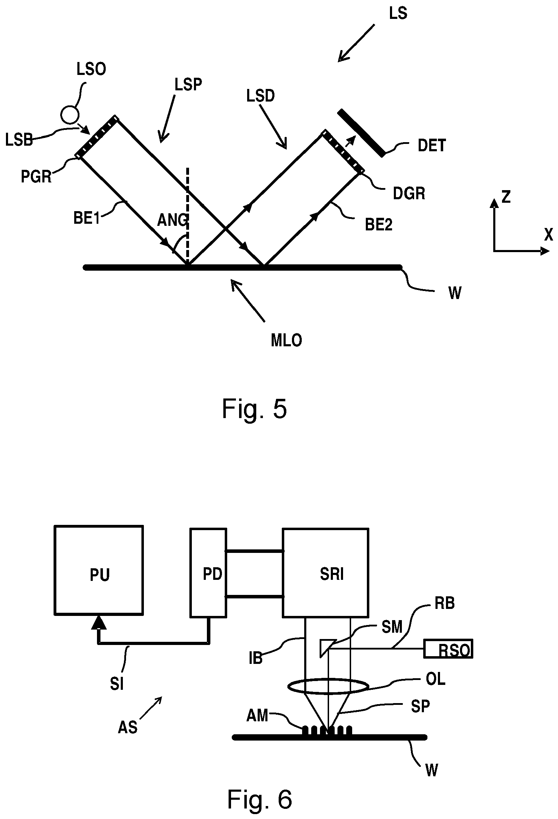

An example of a level or height sensor LS as known in the art is schematically shown in Figure 5, which illustrates only the principles of operation. In this example, the level sensor comprises an optical system, which includes a projection unit LSP and a detection unit LSD. The projection unit LSP comprises a radiation source LSO providing a beam of radiation LSB which is imparted by a projection grating PGR of the projection unit LSP. The radiation source LSO may be, for example, a narrowband or broadband light source, such as a supercontinuum light source, polarized or non-polarized, pulsed or continuous, such as a polarized or non-polarized laser beam. The radiation source LSO may include a plurality of radiation sources having different colors, or wavelength ranges, such as a plurality of LEDs. The radiation source LSO of the level sensor LS is not restricted to visible radiation, but may additionally or alternatively encompass UV and/or IR radiation and any range of wavelengths suitable to reflect from a surface of a substrate.

The projection grating PGR is a periodic grating comprising a periodic structure resulting in a beam of radiation BE1 having a periodically varying intensity. The beam of radiation BE1 with the periodically varying intensity is directed towards a measurement location MLO on a substrate W having an angle of incidence ANG with respect to an axis perpendicular (Z-axis) to the incident substrate surface between 0 degrees and 90 degrees, typically between 70 degrees and 80 degrees. At the measurement location MLO, the patterned beam of radiation BE1 is reflected by the substrate W (indicated by arrows BE2) and directed towards the detection unit LSD.

In order to determine the height level at the measurement location MLO, the level sensor further comprises a detection system comprising a detection grating DGR, a detector DET and a processing unit (not shown) for processing an output signal of the detector DET. The detection grating DGR may be identical to the projection grating PGR. The detector DET produces a detector output signal indicative of the light received, for example indicative of the intensity of the light received, such as a photodetector, or representative of a spatial distribution of the intensity received, such as a camera. The detector DET may comprise any combination of one or more detector types.

By means of triangulation techniques, the height level at the measurement location MLO can be determined. The detected height level is typically related to the signal strength as measured by the detector DET, the signal strength having a periodicity that depends, amongst others, on the design of the projection grating PGR and the (oblique) angle of incidence ANG.

The projection unit LSP and/or the detection unit LSD may include further optical elements, such as lenses and/or mirrors, along the path of the patterned beam of radiation between the projection grating PGR and the detection grating DGR (not shown).

In an embodiment, the detection grating DGR may be omitted, and the detector DET may be placed at the position where the detection grating DGR is located. Such a configuration provides a more direct detection of the image of the projection grating PGR.

In order to cover the surface of the substrate W effectively, a level sensor LS may be configured to project an array of measurement beams BE1 onto the surface of the substrate W, thereby generating an array of measurement areas MLO or spots covering a larger measurement range.

Various height sensors of a general type are disclosed for example in US7265364 and US7646471, both incorporated by reference. A height sensor using UV radiation instead of visible or infrared radiation is disclosed in US2010233600A1, incorporated by reference. In WO2016102127A1, incorporated by reference, a compact height sensor is described which uses a multi-element detector to detect and recognize the position of a grating image, without needing a detection grating.

Another type of metrology tool used in IC manufacture is an alignment sensor. A critical aspect of performance of the lithographic apparatus is therefore the ability to place the applied pattern correctly and accurately in relation to features laid down in previous layers (by the same apparatus or a different lithographic apparatus). For this purpose, the substrate is provided with one or more sets of marks or targets. Each mark is a structure whose position can be measured at a later time using a position sensor, typically an optical position sensor. The position sensor may be referred to as "alignment sensor" and marks may be referred to as "alignment marks".

A lithographic apparatus may include one or more (e.g. a plurality of) alignment sensors by which positions of alignment marks provided on a substrate can be measured accurately. Alignment (or position) sensors may use optical phenomena such as diffraction and interference to obtain position information from alignment marks formed on the substrate. An example of an alignment sensor used in current lithographic apparatus is based on a self-referencing interferometer as described in US6961116. Various enhancements and modifications of the position sensor have been developed, for example as disclosed in US2015261097A1. The contents of all of these publications are incorporated herein by reference.

Figure 6 is a schematic block diagram of an embodiment of a known alignment sensor AS, such as is described, for example, in US6961116, and which is incorporated by reference. Radiation source RSO provides a beam RB of radiation of one or more wavelengths, which is diverted by diverting optics onto a mark, such as mark AM located on substrate W, as an illumination spot SP. In this example the diverting optics comprises a spot mirror SM and an objective lens OL. The illumination spot SP, by which the mark AM is illuminated, may be slightly smaller in diameter than the width of the mark itself.

Radiation diffracted by the alignment mark AM is collimated (in this example via the objective lens OL) into an information-carrying beam IB. The term "diffracted" is intended to include zero-order diffraction from the mark (which may be referred to as reflection). A self-referencing interferometer SRI, e.g. of the type disclosed in US6961116 mentioned above, interferes the beam IB with itself after which the beam is received by a photodetector PD. Additional optics (not shown) may be included to provide separate beams in case more than one wavelength is created by the radiation source RSO. The photodetector may be a single element, or it may comprise a number of pixels, if desired. The photodetector may comprise a sensor array.

The diverting optics, which in this example comprises the spot mirror SM, may also serve to block zero order radiation reflected from the mark, so that the information-carrying beam IB comprises only higher order diffracted radiation from the mark AM (this is not essential to the measurement, but improves signal to noise ratios).

Intensity signals SI are supplied to a processing unit PU. By a combination of optical processing in the block SRI and computational processing in the unit PU, values for X- and Y-position on the substrate relative to a reference frame are output.

A single measurement of the type illustrated only fixes the position of the mark within a certain range corresponding to one pitch of the mark. Coarser measurement techniques are used in conjunction with this to identify which period of a sine wave is the one containing the marked position. The same process at coarser and/or finer levels may be repeated at different wavelengths for increased accuracy and/or for robust detection of the mark irrespective of the materials from which the mark is made, and materials on and/or below which the mark is provided. The wavelengths may be multiplexed and de-multiplexed optically so as to be processed simultaneously, and/or they may be multiplexed by time division or frequency division.

In this example, the alignment sensor and spot SP remain stationary, while it is the substrate W that moves. The alignment sensor can thus be mounted rigidly and accurately to a reference frame, while effectively scanning the mark AM in a direction opposite to the direction of movement of substrate W. The substrate W is controlled in this movement by its mounting on a substrate support and a substrate positioning system controlling the movement of the substrate support. A substrate support position sensor (e.g. an interferometer) measures the position of the substrate support (not shown). In an embodiment, one or more (alignment) marks are provided on the substrate support. A measurement of the position of the marks provided on the substrate support allows the position of the substrate support as determined by the position sensor to be calibrated (e.g. relative to a frame to which the alignment system is connected). A measurement of the position of the alignment marks provided on the substrate allows the position of the substrate relative to the substrate support to be determined.

In order to monitor the lithographic process, parameters of the patterned substrate are measured. Parameters may include, for example, the overlay error between successive layers formed in or on the patterned substrate. This measurement may be performed on a product substrate and/or on a dedicated metrology target. There are various techniques for making measurements of the microscopic structures formed in lithographic processes, including the use of scanning electron microscopes and various specialized tools. A fast and non-invasive form of specialized inspection tool is a scatterometer in which a beam of radiation is directed onto a target on the surface of the substrate and properties of the scattered or reflected beam are measured.

Examples of known scatterometers include angle-resolved scatterometers of the type described in US2006033921A1 and US2010201963A1. The targets used by such scatterometers are relatively large, e.g., 40µm by 40µm, gratings and the measurement beam generates a spot that is smaller than the grating (i.e., the grating is underfilled). In addition to measurement of feature shapes by reconstruction, diffraction based overlay can be measured using such apparatus, as described in published patent application US2006066855A1. Diffraction-based overlay metrology using dark field imaging of the diffraction orders enables overlay measurements on smaller targets. Examples of dark field imaging metrology can be found in international patent applications WO 2009078708 and WO 2009106279 which documents are hereby incorporated by reference in their entirety. Further developments of the technique have been described in published patent publications US20110027704A, US20110043791A, US2011102753A1, US20120044470A, US20120123581A, US20130258310A, US20130271740A and WO2013178422A1. These targets can be smaller than the illumination spot and may be surrounded by product structures on a wafer. Multiple gratings can be measured in one image, using a composite grating target. The contents of all these applications are also incorporated herein by reference.

In the aforementioned metrology or inspection apparatuses, such as for example scatterometers, precise control of wafer position is required to position a wafer in a way such that features with small critical dimensions CDs can be precisely printed or measured. High precision control of wafer position is typically implemented by means of a positioning apparatus which in some cases, may comprise a wafer table WT for holding a wafer, and one or more wafer stages configured to position the substrate holder in one or more directions with respect to an illumination beam of radiation. In some cases, the positioning apparatus may comprise a short stroke stage and a long stroke stage. The short stroke stage provides a relative short travel range but precise positioning whereas the long stroke stage provides a relative long travel range but less precise or coarse positioning. The motion of each wafer stage of the positioning apparatus may be enabled by one or more actuators. For example, electromechanical actuators may be used to actuate coarse movement whereas electromagnetic or piezoelectric actuators may be used to actuate fine movement. High precision wafer positioning cannot be achieved by using high precision wafer stages alone as the wafer positioning performance can be badly degraded by vibrations. Such vibrations may originate from external environment, such as floor vibrations, and internal direct force disturbances, such as disturbances induced by the large accelerations of the wafer stages. Hence, there is a strong desire to further improve the performance of metrology or inspection apparatuses, in particular scatterometer based apparatuses, such that vibration induced performance degradation of such apparatuses can be reduced or minimized. The performance improvement may be achieved by further improving the vibration isolation to the external vibrations in combination with effectively damping the internal direct force disturbances.

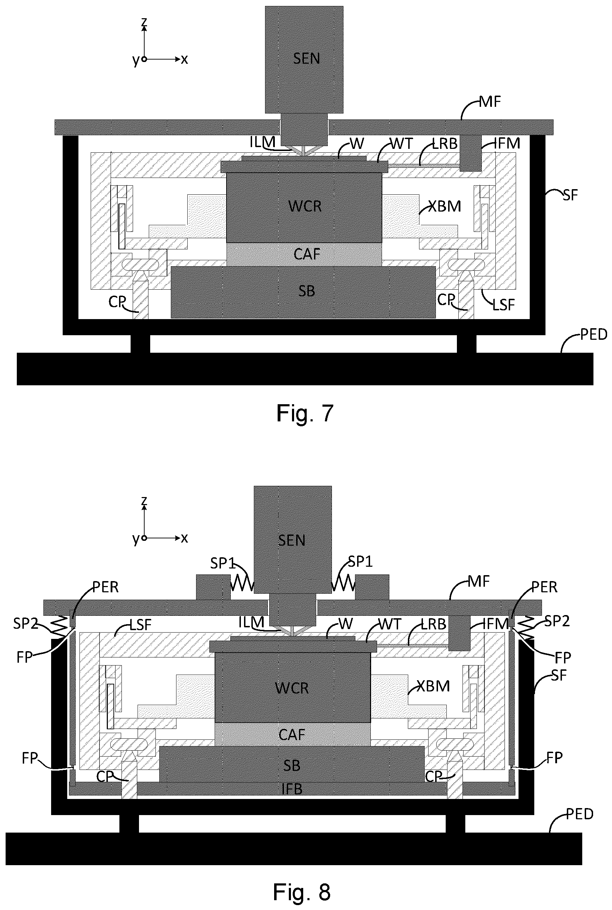

Figure 7 depicts a schematic overview of an existing scatterometer based metrology device according to a prior art example. In the example of Figure 7, the basic mechanical structure of a scatterometer based metrology device may comprise several parts. The first part may be a pedestal PED which is a heavy and stiff structure used to connect the metrology device with the factory floor. Another main part may be a stage frame SF which is mounted directly and stiffly to the heavy pedestal PED without any vibration isolation measures and hence provides a rigid base frame for supporting the modules, such as the aforementioned positioning apparatus of the metrology device. The projection module or sensor module SEN which may comprise a projection unit and/or a detection unit is firmly held by a sensor frame or metrology frame MF. Through the sensor module, a conditioned illumination beam of radiation may be focused on a metrology target on the surface of a wafer; and one or more high diffraction orders that carry the information of the target may be collected by the sensor module to form an image of the target on a detector. The metrology frame MF may be supported by the stage frame.

As illustrated in Figure 7, a wafer support or wafer table WT may be used to hold a wafer. The wafer table WT may be mounted on a wafer carrier WCR which is part of the positioning apparatus (not shown). The wafer carrier WCR may comprise a short stroke stage (not shown) configured to provide precise positioning for the wafer table WT with up to six degrees of freedom (DOF). The travel range of the short stroke stage is relatively short, for example, tens of micrometres. A laser based interferometric position sensor IFM may be used for accurate determination of wafer position. The interferometric position sensor IFM may be mounted to the metrology frame MF. A laser beam LRB may be emitted from the interferometric position sensor IFM and subsequently reflected off the side surface of the wafer table WT which holds the wafer W. The reflected laser beam may be used to form an interference pattern, the information of which can then be used to accurately determine the current wafer position with respect to the illumination beam of radiation. The information of wafer position determined by the interferometric position sensor IFM may be sent to a stage controller configured to control stage motion such that a closed-loop feedback control of wafer stages can be implemented.

In the example of Figure 7, the wafer carrier WCR may be required to provide stage motion only in 3 DOF instead of conventional 6 DOF using an arrangement herein referred to as an H-drive (or similar arrangement). The details of the H-drive are disclosed in US patent US6635887 B2 which is incorporated herein by reference. The H-drive may comprise an X-beam XBM and two Y-beams. These beams are so called because they are generally parallel to the orthogonal X and Y axes of the reference coordinate system defined for the apparatus in Figure 7. The X-beam XBM may be connected to the Y-beams by means of Y-sliders not shown allowing the X-beam to be displaceable in the Y direction. In addition, the wafer carrier incorporating the short stroke stage may be placed next to or on top of the X-beam. The wafer carrier WCR, or more specifically the short stroke stage, may be placed next to or on top of the X-beam XBM such that the wafer carrier WCR can be displaceable longitudinally of the X-beam XBM substantially without friction. However, the wafer carrier WCR may be restrained relative to the X-beam XBM so that it cannot move in the Y and Z directions, nor yaw (i.e., rotation about Z-axis or Rz). The non-contact air connection also provides good vibration isolation between the wafer carrier WCR and the X-beam XBM. Displacement of the wafer carrier WCR longitudinally of X-beam XBM and displacement of X-beam XBM in the Y direction allows wafer table WT to be positioned coarsely in the X-Y plane. Independent control of Y-sliders further allows the rotational position of wafer table WT about the Z-axis (yaw or Rz) to be controlled within a certain range. Therefore, the H drive module can be considered as a long stroke stage. Note that, the above-described H drive is only one example of a long stroke stage arrangement, and other designs of long stroke stage control arrangements can be used for all concepts disclosed herein.

The short stroke stage may be actuated in the X, Y and Rz directions by means of one or more actuators; e.g., Lorentz-force driven electromagnetic actuators. Such Lorentz actuators together with foregoing air bearings may form a non-contact connection between the short stroke stage and the long stroke stage, e.g., the X-beam of the H drive module. The long stroke stage may hold the short stroke stage via such a non-contact connection. The long stroke stage may be also actuated by means of actuators; e.g., one or more Lorentz-force driven electromagnetic actuators. As illustrated in Figure 7, the X-beam XBM may be supported by a long stroke stage frame LSF which works as a Y-direction balance mass. The long stroke stage frame LSF (indicated by diagonal hatching) may connect stiffly to the stage frame SF via two or more connection points CP, resulting in the transmission of the actuator reaction forces to the stage frame and hence the pedestal PED. The wafer carrier WCR may connect to a stage base SB by means of a vibration isolation device, such as a carrier air foot CAF, which may be configured to be stiff in the Z, Rx (rotation about X-axis) and Ry (rotation about Y-axis) directions. The stage base SB which supports the wafer carrier WCR via the carrier air foot CAF may be supported by the stage frame SF.

Figure 8 depicts a schematic overview of an improved vibration isolation system which may be incorporated in a (e.g., scatterometer based) metrology device according to a first embodiment. In comparison with the exemplary metrology device of Figure 7, the embodiment of Figure 8 further comprises vibration isolation measures for better isolating sensitive components from both internal and external vibrations, and an intermediate frame suspended from the metrology frame MF.

Vibration isolation measures, such as for example first spring elements SP1 may be used to reduce the transmission of metrology frame vibrations to the sensor module SEN in the horizontal plane or x-y plane (e.g., a plane parallel to a main surface plane of the wafer) with reference to the coordinate system shown in Figure 8. Additional vibration isolation measures, e.g., second spring elements SP2 may be implemented to provide certain compliance for the metrology frame which holds the sensor module. In this manner, the metrology frame MF may be at least substantially decoupled from the stage frame.

To some extent, the aforementioned vibration isolation measures, e.g. SP1 and SP2, may be useful for reducing the impact of both internal and external vibrations. However, only using such vibration isolation devices (i.e., without the proposed intermediate frame suspended from the metrology frame MF) may not be sufficient for providing a desired (quiet) operating environment for vibration sensitive apparatuses and therefore further improvement may be needed. The metrology frame MF may be subject to external vibrations. In response to such external vibrations, the compliance of the second spring elements SP2 causes different spring elements to have different levels of deformation. Since the metrology frame MF is at least substantially decoupled from the stage frame and the stage base SB, different levels of deformation in second spring elements SP2 may result in tilting of the metrology frame MF with respect to the stage frame SF. In the cases where the stage base is stiffly supported by the stage frame SF, tilting of the metrology frame MF with respect to stage frame SF can result in formation of a tilting angle between the metrology frame MF and the stage base SB, corresponding to a tilting angle between the sensor module SEN and the wafer W.

Similarly, in the cases where the stage base SB is connected to the stage frame SF via vibration isolation devices, e.g., the third spring elements SP3 (not shown), the stage base SB may be tilted with respect to the stage frame SF. This is because longitudinal displacement of the wafer carrier WCR along the X-beam XBM changes the center of the combined mass of the stage base SB and the wafer carrier WCR. In response to such shift of the mass center, the compliance of the third spring elements SP3 causes different spring elements to have different levels of deformation, which results in tilting of the stage base SB with respect to the stage frame SF. Since the metrology frame MF is at least substantially decoupled from the stage base SB, the tilting of the stage base SB with respect to the stage frame SF may further lead to a tilting angle between the metrology frame MF and the stage base SB, and hence between the sensor module SEN and the wafer W.

The tilting angle may be in the order of several millirads (mrad). For example, the tilting angle may be in the range between 1 and 10 mrad. This degree of tilt exceeds the typical angular tolerance range of the interferometric position sensor IFM and hence will result in significant reduction in position measurement accuracy. In the cases where the tilting angle between the stage base SB and the metrology frame MF is sufficiently large, the interferometric position sensor IFM becomes non-functional. The tilt between the metrology frame can result in horizontal shifting of target features with respect to the focused illumination beam of radiation ILM and consequently positioning errors in the X-Y plane. Due to their degraded performance, the tilted interferometric position sensor IPS and the tilted Lorentz-force driven actuators can further increase the X-Y plane positioning errors.

Moreover, the spring based vibration isolation measures, e.g., the second spring elements SP2, and third SP3 are designed such that the transmission of external vibrations and internal actuator induced disturbances to the metrology frame MF and the stage base SB is significantly reduced. This is typically achieved by carefully choosing a resonant frequency of either the metrology frame or the stage base to be less than the vibration frequencies. For a mass-spring system, the natural frequency is determined by the stiffness of the spring and the mass that the spring carries. Since the masses of the metrology frame MF and the stage base SB are known, the natural frequencies of both mass-spring systems, i.e., metrology frame and stage base, can be properly set by choosing suitable spring stiffness. To provide a broad isolation frequency range, a low natural frequency is desirable. Although the use of springs helps reduce the transmission of vibrations with frequencies higher than the natural frequency of the mass-spring system, the mass will still vibrate at the natural frequency. In this regard, both the stage base SB and the metrology frame MF vibrate substantially along the Z direction on the respective spring elements at the respective frequencies. The vibrations of the stage base SB and the metrology frame MF result in relative movement between the focal plane of the illumination beam of radiation ILM and the metrology targets on the surface of the wafer. Since the focus optimization mechanism which evaluates and optimizes the focusing condition of the metrology system is in idle state during measurement, relative movement of the wafer with respect to the focal plane in the Z direction can cause significant focusing errors or Z direction positioning errors.

Positioning errors are detrimental to measurement accuracy of a scatterometer based metrology device and any other types of metrology/inspection devices in general. Hence, in order to overcome the aforementioned issues, the intermediate frame may be used to further reduce the impact of vibrations to the positioning apparatus. As illustrated in Figure 8, the intermediate frame may comprise two or more struts or rods, herein referred to as pendulum rods PER and an intermediate frame base IFB. The intermediate frame may be configured such that the two or more pendulum rods PER connect the intermediate frame base IFB to the metrology frame MF. In contrast to the example of Figure 7, the stage base SB is supported on the intermediate frame base IFB and therefore is suspended from the metrology frame MF, rather than being connected to the stage frame SF via third spring elements SP3. As such, the wafer carrier WCR in this embodiment is suspended from the metrology frame MF.

The pendulum rods PER may be configured such that they are stiff in the Z direction and compliant in the horizontal plane i.e., the X-Y plane such that the system of intermediate frame and pendulum rods can be thought of as a pendulum system (at least insofar as the intermediate frame is hung from the metrology frame MF via the pendulum rods with compliance in the XY plane). Each of the pendulum rods PER may, for example, comprise two flexure points FP. For example each flexure point FP may be formed by locally reducing the cross sectional area of the pendulum rod (although any other suitable method for obtaining horizontal compliance may be used). Such flexure points FP may enable the compliance of the pendulum rods PER in the horizontal plane. At each flexure point, a portion on one side of the flexure point may be able to pivot and/or swivel with respect to a portion on the other side of the flexure point. The top end of each pendulum rod may be fixed to the metrology frame MF by means of for example, conventional fixings (e.g., nuts and bolts) or welding, at a position above the upper flexure point. Similarly, the bottom end of each pendulum rod may be fixed to the intermediate frame base using the same or a similar fixing technique at a position below the lower flexure point. Each flexure point FP may be configured such that the natural frequency of the intermediate frame is substantially different than that of the metrology frame.

According to the first embodiment, since the intermediate frame connects the stage base SB directly to the metrology frame MF, both the stage base and the metrology frame are at least substantially isolated from the stage frame vibrations. In addition, the stiff connection in Z means that the metrology frame MF and wafer table WT are constrained together in Rx, Ry and Z and as such the employment of the intermediate frame prevents the formation of the tilting angle between the wafer W and the metrology frame MF e.g., due to displacement of the wafer carrier WCR. Consequently, the aforementioned tilting induced performance degradation of the interferometric position sensor IPS and the X-Y plane positioning errors are both prevented. The wafer carrier WCR should follow the metrology frame MF in 6DOF (X, Y, Rz, Z, Rx, Ry). This can be achieved with a 6DOF controlled stage (which requires interferometers and actuators for each of the 6 DOF) or by using the pendulum method here, where metrology frame MF and wafer table WT are constrained together in Rx, Ry and Z, requiring only a 3 DOF (X, Y, Rz) controlled stage. A pendulum is much cheaper than three additional interferometers and actuators.

However, external disturbances as well as displacement of the wafer carrier WCR can still cause the entire suspended structure, which comprises the metrology frame MF and the intermediate frame, to have an absolute tilt, and/or a tilt with respect to the stage frame SF. As the X-beam XBM is fixed to the stage frame SF, the tilting of the entire suspended structure with respect to the stage frame SF results in gap variations in the actuators sandwiched between the short stroke stage and the X-beam XBM and leads to performance degradation of the actuators. Moreover, internal disturbances that are induced by e.g., reaction forces of the actuators, can excite stage base vibrations, substantially in the X-Y plane. When such X-Y plane vibrations are coupled to the pendulum rods PER, the intermediate frame will pivot and/or swivel with respect to the metrology frame MF, resulting in large X-Y plane displacements of the stage base SB, with respect to the metrology frame MF. Such X-Y plane displacements can result in horizontal shifting of target features with respect to the focused illumination beam of radiation ILM, which can be subsequently corrected by means of the interferometric position sensor IPS. However, the X-Y plane displacements can also translate to Z direction offset. Since the focus optimization mechanism is in the idle state during measurement, the Z direction offset will lead to large Z direction positioning errors.

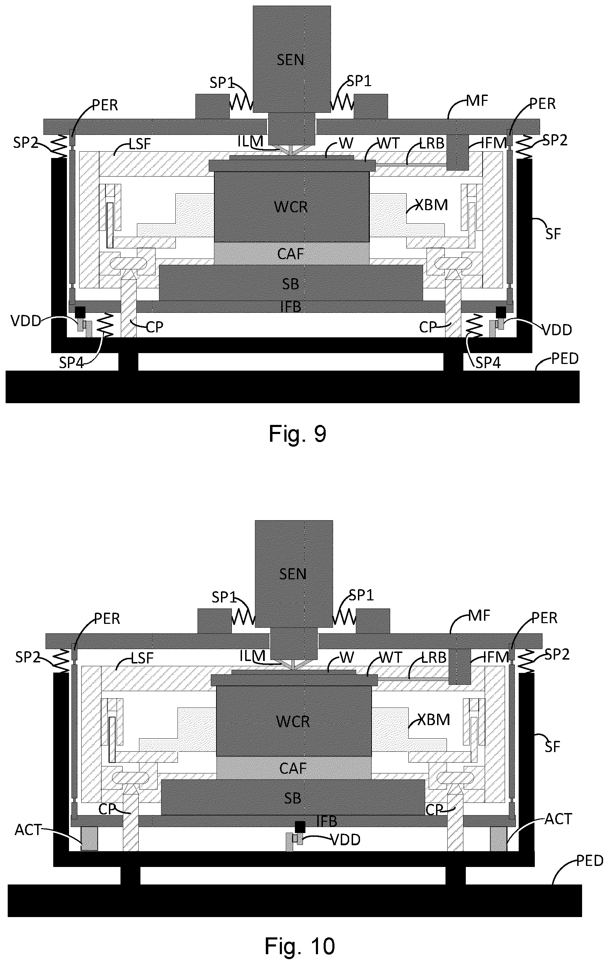

Further improvement is desirable to reduce or remove such X-Y displacements of the stage base induced by the internal disturbances, e.g., actuator reaction forces. Figure 9 depicts another improved vibration isolation system which may be incorporated in a (e.g., scatterometer based) metrology device according to a second embodiment. The second embodiment of Figure 9 improves on the first embodiment of Figure 8 by incorporating a movement compensation system. In the embodiment here, the movement compensation system comprises one or more vibration damping devices VDD or (e.g., horizontal) dampers which are used to damp vibrations of the stage base in the X, Y plane. Each of the vibration damping devices VDD may therefore couple the intermediate frame base IFB to the stage frame SF. In this manner, stage base vibrations, e.g., X-Y plane vibrations, can be significantly damped.

In the cases where the pendulum rods PER provide sufficient stiffness to limit the Rz movement, a single vibration damping device VDD placed at or near the center of the intermediate frame base IFB may be used; e.g., which damps only horizontal or X-Y plane vibrations. However, should additional damping be required for damping Rz vibrations, a second vibration damping device VDD may be employed. If placing a vibration damping device VDD at or near the center of the intermediate frame base IFB is undesired (e.g., to avoid creating holes in the intermediate frame base IFB), multiple vibration damping devices may instead be placed on the intermediate frame base IFB. For example, at least three dampers may be placed, each at different locations on the edge of the intermediate frame base IFB (e.g., equi-angularly spaced) in order to damp vibrations in X, Y and Rz directions.

In addition, the movement compensation system may further comprise one or more stiffening elements or spring elements SP4 to provide the intermediate frame with a certain degree of stiffness in the Z direction, which helps limit the tilt of the entire suspended structure comprising the intermediate frame and the metrology frame MF. For example, when placed on the edge of the intermediate frame base IFB, at least three stiffening elements or spring elements SP4 may be used to provide stiffness in Rx and Ry directions. The stiffness of the stiffening elements or spring elements SP4 may be adjustable, for example, via choosing suitable spring elements SP4, or adjustment of adjustable spring elements. However, in comparison to the first embodiment, this extra stiffness in the Z direction increases the natural frequency of the metrology frame MF, leading to a wider frequency window of stage frame vibrations transmissible to the stage base SB and the metrology frame MF. As a consequence, the Z-direction positioning accuracy of the metrology device may be negatively impacted. Note that, in some embodiments the stiffening elements or spring elements SP4 may be separate to the vibration damping devices VDD. Alternatively or in addition, the stiffening elements or spring elements SP4 may be arranged in series with the vibration damping devices and placed between the vibration damping devices and the stage frame SF.

Figure 10 depicts a different improved vibration isolation system, which may be incorporated in a (e.g., scatterometer based) metrology device according to a third embodiment. The movement compensation system of this embodiment comprises (e.g., at least two) actuation devices ACT and a single vibration damping device VDD. Instead of using stiffening elements to restrict the absolute tilt of the metrology frame MF, this embodiment uses actuation devices ACT for tilting compensation. Each of the additional actuation devices ACT may comprise, for example, a Lorentz-force driven actuator and may be configured to actively compensate for the tilt of the entire suspended structure (comprising the intermediate frame and the metrology frame MF) resulting from movement of the wafer carrier WCR. Note that, other types of motion actuators than Lorentz-force driven actuators, such as reluctance force actuators, are equally applicable for use in the actuation devices. The single vibration damping device VDD (which may be similar to those illustrated in Figure 9) may be provided to damp the X-Y vibrational motion of the stage base SB. The vibration damping device VDD may be placed at or near the center of the stage frame, for example. In embodiments where stiffness in a certain degree of freedom, e.g., Rz, is not provided by the actuation devices ACT (e.g., only two actuation devices are provided to control Rx and Ry), one or more stiffening elements or spring elements SP4 may also be used. Note that using only two actuators to control in Rx and Ry requires installing them at an angle with a hinge point. To avoid, this, at least three actuators may be preferable.

The actuators may be operable in a feedforward control scheme where control signal is computed, either online or offline, on the basis of the knowledge of the system's response to the direct disturbance and the transfer function between the control signal and the controlled output (e.g., obtained from prior observation). Optionally, such a feedforward control scheme may be combined with a feedback control scheme to further improve the positioning accuracy of the positioning apparatus.

When operated in a feedforward control scheme, the motion of the stage base SB resulting from the internal disturbances induced by e.g., actuator's reaction forces, may be studied in advance. For example, the tilt of the entire suspended structure (comprising the intermediate frame and the metrology frame MF) may be recorded for each different movement of the wafer carrier WCR. The recorded motion data may be converted into either a mathematical model or a look-up table, which may be used subsequently by a controller of the actuation devices ACT. During operation, a target movement of the wafer carrier WCR may be sent to the controller. Using either the pre-defined mathematical model or the look-up table, the controller can predict a tilt of the entire suspended structure (comprising the intermediate frame and the metrology frame MF) and will command one or both actuation devices to make corrective movement during or after the movement of the wafer carrier WCR such that the tilt of the entire suspended structure (comprising the intermediate frame and the metrology frame MF) is compensated.

Since this third embodiment may employ fewer or no stiffening elements than many of the other embodiments, the overall stiffness in the Z direction of the connection between the intermediate frame base IFB and the stage frame SF may be reduced with respect to the previous embodiment. A less stiff connection narrows the frequency window of stage frame vibrations transmissible to the stage base SB and thus improves the Z direction positioning accuracy.

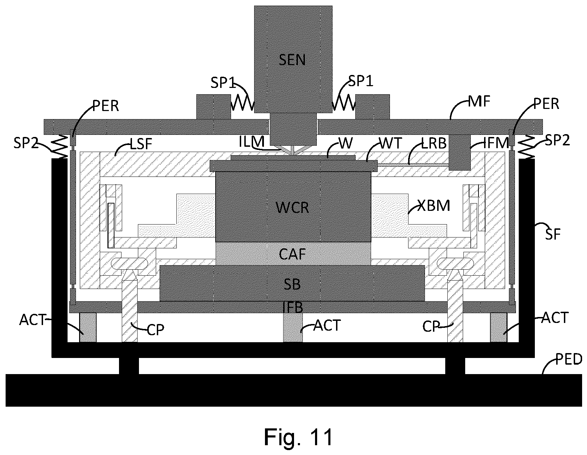

Figure 11 depicts another embodiment of an improved vibration isolation system which may be incorporated in a (e.g., scatterometer based) metrology device according to a fourth embodiment. In contrast to the third embodiment of Figure 10, the movement compensation system of the fourth embodiment comprises only actuation devices ACT and dispenses with the vibration damping device(s) VDD and stiffening elements SP4. This requires additional (e.g., at least two more) actuation devices ACT configured to effectively work as horizontal dampers to correct X-Y plane motion of the intermediate frame base IFB (and the stage base SB). The actuation devices ACT may be configured to make corrective movement in e.g., X, Y, and prevent tilt such that the X-Y plane displacements of the stage base SB and the tilt of the suspended structure (comprising the intermediate frame ITF and the metrology frame MF) can all be compensated. Similar to the third embodiment, the actuation devices ACT may also be operable in a feedforward control scheme as has been described. Optionally, such a feedforward control scheme may be combined with a feedback control scheme to further improve the positioning accuracy of the positioning apparatus.

Note that other different combinations of vibration damping devices VDD, stiffening elements, and actuation devices should be equally applicable for the purpose of displacement and tilting compensation for the stage base SB. Alternatively, in another different embodiment, the flexure points of each pendulum rod may be removed such that the rods are stiff in all X, Y, and Z directions instead of being only stiff in the Z direction. In such a manner, the X-Y plane displacements of the stage base SB can be obviated. A single vibration damping device VDD or a single actuation device ACT may be used to either passively limit or actively compensate the tilt of the suspended structure which comprises the intermediate frame and the metrology frame MF.

Further embodiments are disclosed in the subsequent numbered clauses:
1. An apparatus for improving vibration isolation for a vibration sensitive device, comprising:
   a module frame for supporting a projection module of the vibration sensitive device; and
   an intermediate frame for supporting an object support system of the vibration sensitive device, said object support system being configured for supporting an object;
   wherein the intermediate frame is suspended from the module frame with a connection between the module frame and the intermediate frame being stiff in at least a first direction, the first direction being perpendicular to a main surface plane of said object, said plane or a plane parallel thereto defining a second and third direction.
2. An apparatus as defined in claim 1, wherein said stiffness of the connection between the module frame and the intermediate frame is configured to minimize a relative angular tilt between the projection module and object support system.
3. An apparatus as defined in clause 1 or 2, wherein the intermediate frame constrains the object support system to follow the module frame in three degrees of freedom comprising: displacement in the first direction, rotation around the second direction and rotation around the third direction.
4. An apparatus as defined in any of preceding clauses, wherein the intermediate frame comprises an intermediate frame base configured to support the object support system and at least two rods configured to suspend the intermediate frame base from the module frame, said rods providing said stiffness between the module frame and the intermediate frame.
5. An apparatus as defined in clause 4, wherein the rods are configured to provide compliance in the second and third directions.
6. An apparatus as defined in clause 5, wherein each of the at least two rods comprises at least one flexure point to provide said compliance.
7. An apparatus as defined in clause 5 or 6 wherein each of the at least two rods comprises two flexure points to provide said compliance.
8. An apparatus as defined in clause 6 or 7, wherein the at least one flexure point each comprises a reduced cross sectional area with respect to that of a main portion of the rod.
9. An apparatus as defined in any preceding clause, further comprising an object support frame, and at least one vibration isolation device, being configured such that the module frame is supported by the object support base via the at least one vibration isolation device.
10. An apparatus as defined in clause 9, further comprising a movement compensation system operable to damp and/or compensate movement in the second and third directions and/or a tilt of an object support base of the object support system with respect to the object support frame, said object support base being supported by the intermediate frame.
11. An apparatus as defined in clause 10, wherein the movement compensation system comprises one or both of:
   at least one vibration damping device configured to damp vibrations of the object support base in at least the second and third directions; and
   at least one actuation device configured to actively compensate movement of an object support carrier of the object support system in at least one direction.
12. An apparatus as defined in clause 11, wherein each at least one vibration damping device connects the intermediate frame to the object support frame.
13. An apparatus as defined in clause 11 or 12, further comprising at least one stiffening element configured to provide stiffness between the object support base and the object support frame in the first direction.
14. An apparatus as defined in clause 13, wherein each stiffening element is comprised between a respective one of said vibration damping devices and said object support frame.
15. An apparatus as defined in any of clauses 11 to 14, wherein the at least one actuation device comprises at least one motion actuator.
16. An apparatus as defined in clause 11 or 15, wherein the at least one actuation device is configured to operate in a feedforward control scheme to compensate an expected movement of the object support base resultant from the movement of the object support carrier.
17. An apparatus as defined in any of clauses 11 to 16, wherein the movement compensation system comprises only said vibration damping devices and said stiffening elements, together configured to damp vibrations in the second and third directions and prevent tilt.
18. An apparatus as defined in clause 17, wherein the movement compensation system comprises at least one of said vibration damping devices and at least three of said stiffening elements.
19. An apparatus as defined in any of clauses 11 to 16, wherein the movement compensation system comprises at least two of said actuation devices configured to actively compensate movement of an object support carrier of the object support system in at least two degrees of freedom.
20. An apparatus as defined in clause 19, configured such that the active compensation of said at least two actuation devices reduce or prevent tilt of the object support base with respect to the object support frame.
21. An apparatus as defined in clause 19 or 20, configured such that the active compensation of said at least two actuation devices reduces or prevents tilt of the object support base with respect to the object support frame without additional stiffening.
22. An apparatus as defined in clause 19 or 20, further comprising at least one vibration damping device configured to damp vibrations of the object support base in at least the second and third directions.
23. An apparatus as defined in any of clauses 19 to 22, comprising at least two further actuation devices configured to actively compensate movement of an object support carrier of the object support system in at least the second and third directions.
24. An apparatus as defined in any preceding clause, wherein the projection module is configured to provide an illumination beam of radiation to an object supported on an object support of the object support system; and the object support system comprises a positioning apparatus for precisely positioning the object with respect to the illumination beam of radiation.
25. A metrology or inspection device comprising an apparatus as defined in any of preceding clauses.
26. The metrology or inspection device as defined in clause 25, comprising:
   a sensor module as the projection module supported by the module frame; and
   being operable to perform a measurement on an object supported by the object support system.
27. The metrology device as defined in clause 26 being one of a scatterometer device, an alignment device, a leveling device, an e-beam apparatus, or a reticle inspection apparatus.
28. A lithographic exposure tool comprising an apparatus as defined in any of clauses 1 to 24.
29. The lithographic exposure tool as defined in clause 27, comprising:
   an exposure projection module as the projection module supported by the module frame; and
   being operable to:
      expose a pattern on a substrate supported by the object support system and/or expose a pattern via a patterning device supported by the object support system on a substrate.

The vibration isolation systems disclosed herein find applicability within, and may comprise part of, a vibration sensitive apparatus, such as a particle beam apparatus, an e-beam apparatus, an e-beam inspection apparatus, a metrology apparatus (including a scatterometer apparatus), a vacuum apparatus, reticle inspection tool or a lithography apparatus for example. In the latter two examples, the object being carried by the support may be a reticle (or mask), rather than (or additional to) a wafer or substrate, for patterning a beam in a lithographic apparatus; and the vibration isolation system may be configured to provide excellent/desired stability to the positioning apparatus of a reticle stage and/or the wafer stage. As such, the projection module (which in all examples projects a beam at an object held by an object support system) may be a sensor module in the context of a metrology device or a lithographic projection module in the context of a lithographic device or scanner.

The terms "radiation" and "beam" used in relation to the lithographic apparatus encompass all types of electromagnetic radiation, including ultraviolet (UV) radiation (e.g., having a wavelength of or about 365, 355, 248, 193, 157 or 126 nm) and extreme ultra-violet (EUV) radiation (e.g., having a wavelength in the range of 5-20 nm), as well as particle beams, such as ion beams or electron beams.

The term "lens", where the context allows, may refer to any one or combination of various types of optical components, including refractive, reflective, magnetic, electromagnetic and electrostatic optical components.

The foregoing description of the specific embodiments will so fully reveal the general nature of the invention that others can, by applying knowledge within the skill of the art, readily modify and/or adapt for various applications such specific embodiments, without undue experimentation, without departing from the general concept of the present invention. Therefore, such adaptations and modifications are intended to be within the meaning and range of equivalents of the disclosed embodiments, based on the teaching and guidance presented herein. It is to be understood that the phraseology or terminology herein is for the purpose of description by example, and not of limitation, such that the terminology or phraseology of the present specification is to be interpreted by the skilled artisan in light of the teachings and guidance.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1. An apparatus for improving vibration isolation for a vibration sensitive device, comprising:
a module frame for supporting a projection module of the vibration sensitive device; and
an intermediate frame for supporting an object support system of the vibration sensitive device, said object support system being configured for supporting an object;
wherein the intermediate frame is suspended from the module frame with a connection between the module frame and the intermediate frame being stiff in at least a first direction, the first direction being perpendicular to a main surface plane of said object, said plane or a plane parallel thereto defining a second and third direction.

2. An apparatus as claimed in claim 1, wherein said stiffness of the connection between the module frame and the intermediate frame is configured to minimize a relative angular tilt between the projection module and object support system.

3. An apparatus as claimed in claim 1 or 2, wherein the intermediate frame constrains the object support system to follow the module frame in three degrees of freedom comprising: displacement in the first direction, rotation around the second direction and rotation around the third direction.

4. An apparatus as claimed in any of preceding claims, wherein the intermediate frame comprises an intermediate frame base configured to support the object support system and at least two rods configured to suspend the intermediate frame base from the module frame, said rods providing said stiffness between the module frame and the intermediate frame.

5. An apparatus as claimed in any preceding claim, further comprising an object support frame, and at least one vibration isolation device, being configured such that the module frame is supported by the object support base via the at least one vibration isolation device.

6. An apparatus as claimed in claim 5, further comprising a movement compensation system operable to damp and/or compensate movement in the second and third directions and/or a tilt of an object support base of the object support system with respect to the object support frame, said object support base being supported by the intermediate frame.

7. An apparatus as claimed in claim 6, wherein the movement compensation system comprises one or both of:
at least one vibration damping device configured to damp vibrations of the object support base in at least the second and third directions; and
at least one actuation device configured to actively compensate movement of an object support carrier of the object support system in at least one direction.

8. An apparatus as claimed in claim 7, wherein the at least one actuation device is configured to operate in a feedforward control scheme to compensate an expected movement of the object support base resultant from the movement of the object support carrier.

9. An apparatus as claimed in claim 7 or 8, wherein the movement compensation system comprises only said vibration damping devices and said stiffening elements, together configured to damp vibrations in the second and third directions and prevent tilt.

10. An apparatus as claimed in claim 7 or 8, wherein the movement compensation system comprises at least two of said actuation devices configured to actively compensate movement of an object support carrier of the object support system in at least two degrees of freedom.

11. An apparatus as claimed in claim 10, configured such that the active compensation of said at least two actuation devices reduce or prevent tilt of the object support base with respect to the object support frame.

12. An apparatus as claimed in claim 10 or 11, configured such that the active compensation of said at least two actuation devices reduces or prevents tilt of the object support base with respect to the object support frame without additional stiffening.

13. An apparatus as claimed in any preceding claim, wherein the projection module is configured to provide an illumination beam of radiation to an object supported on an object support of the object support system; and the object support system comprises a positioning apparatus for precisely positioning the object with respect to the illumination beam of radiation.

14. A metrology or inspection device comprising an apparatus as claimed in any of preceding claims.

15. A lithographic exposure tool comprising an apparatus as claimed in any of claims 1 to 13.
